(19) Europäisches Patentamt
European Patent Office
Office européen des brevets

(11) **EP 2 425 558 B1**

(12) **EUROPÄISCHE PATENTSCHRIFT**

(45) Veröffentlichungstag und Bekanntmachung des Hinweises auf die Patenterteilung:
**19.03.2014 Patentblatt 2014/12**

(21) Anmeldenummer: **10720372.1**

(22) Anmeldetag: **28.04.2010**

(51) Int Cl.:
***H04B 10/116*** (2013.01)

(86) Internationale Anmeldenummer:
**PCT/EP2010/055703**

(87) Internationale Veröffentlichungsnummer:
**WO 2010/125093 (04.11.2010 Gazette 2010/44)**

(54) **VERFAHREN UND VORRICHTUNG ZUR OPTISCHEN ÜBERTRAGUNG VON DATEN**

METHOD AND DEVICE FOR OPTICALLY TRANSMITTING DATA

PROCÉDÉ ET DISPOSITIF DE TRANSFERT OPTIQUE DE DONNÉES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.04.2009 DE 102009019202**

(43) Veröffentlichungstag der Anmeldung:
**07.03.2012 Patentblatt 2012/10**

(73) Patentinhaber: **Siemens Aktiengesellschaft 80333 München (DE)**

(72) Erfinder: **WALEWSKI, Joachim 82008 Unterhaching (DE)**

(56) Entgegenhaltungen:
**WO-A1-2007/004530 WO-A1-2008/001262 WO-A2-02/25842**

**Beschreibung**

Die Erfindung betrifft ein Verfahren und eine Vorrichtung zur optischen Übertragung von Daten mittels einer pulsbreitenmodulierten Lichtquelle.

Die weite Verbreitung von mobilen Endgeräten, wie beispielsweise mobilen Telefonen, erfordert eine schnelle Datenübertragung über drahtlose Schnittstellen und drahtlose lokale Datennetzwerke. In Gebäuden können lichtemittierende Dioden (LED) zur Beleuchtung von Räumen eingesetzt werden. Lichtemittierende Dioden, auch Leuchtdioden genannt, zeichnen sich durch einen niedrigen Energieverbrauch und eine lange Lebensdauer aus. Zur Beleuchtung von Räumen innerhalb von Gebäuden werden dort vorgesehene Leuchtdioden mit einer Pulsbreitenmodulation moduliert, um die Beleuchtungsstärke innerhalb eines Raumes entsprechend den jeweiligen Anforderungen einstellen zu können. Eine Pulsbreitenmodulation zum Zwecke einer Helligkeitseinstellung wird in der Fachwelt auch als »Dimming « bezeichnet.

Zur gleichzeitigen Helligkeitseinstellung und Datenübertragung über eine Lichtquelle sind bereits Verfahren bekannt. In einer am 28.04.2009 mit dem Aktenzeichen 102009019203.4 beim Deutschen Patent- und Markenamt und als DE 102010005885 veröffentlichten hinterlegten Patentanmeldung wurde bereits vorgeschlagen, ein Tastverhältnis der Pulsbreitenmodulation in einzelnen Pulsbreitenmodulationszyklen so zu ändern, dass mit Hilfe eines solchen zyklusabhängigen Tastverhältnis zu übertragende Daten kodiert werden, ohne dass die eingestellte Helligkeit insgesamt eine Veränderung erfährt. Zur Beibehaltung der eingestellten Helligkeit soll dabei der Wert eines über eine Mehrzahl von zyklusabhängigen Tastverhältnissen gebildeten arithmetischen Mittels im Wesentlichen dem eingestellten Tastverhältnis entsprechen.

WO 02/25842 A2 betrifft Beleuchtungsvorrichtungen, die eine dimmbare bzw. einstellbare Beleuchtung ermöglichen und gleichzeitig zur drahtlosen Kommunikation eingesetzt werden können.

Es ist eine Aufgabe der vorliegenden Erfindung, ein Verfahren und eine Vorrichtung zur optischen Übertragung von Daten über eine dimmbare Lichtquelle zu schaffen, die gegenüber dem Stand der Technik eine höhere Datenübertragungsrate gewährleistet.

Diese Aufgabe wird erfindungsgemäß durch ein Verfahren mit den im Patentanspruch 1 angegebenen Merkmalen gelöst.

Die Erfindung schafft ein Verfahren zur optischen Übertragung von Daten mittels einer pulsbreitenmodulierten Lichtquelle, bei dem ein zur Helligkeitseinstellung der pulsbreitenmodulierten Lichtquelle eingestelltes Tastverhältnis als Verhältnis zwischen einer Dunkelzeit der Lichtquelle und einer Periodenlänge eines Pulsbreitenmodulationszyklus vorgegeben ist.

Erfindungsgemäß wird eine Hellzeit innerhalb eines Pulsbreitenmodulationszyklus mit mindestens einer Dunkeltastung in mindestens eine erste und zweite Teilhellzeit aufgeteilt wird, so dass über Beginn und/oder zeitliche Länge der mindestens einen jeweiligen Dunkeltastung die zu übertragenden Daten kodiert werden. Die Summe der Teilhellzeiten innerhalb des Pulsbreitenmodulationszyklus entspricht dabei im Wesentlichen der Hellzeit gemäß dem vorgegebenen Tastverhältnis.

Die Erfindung ist von der Idee getragen, das eingestellte Tastverhältnis, welches einer über einen Dimmfaktor eingestellten Helligkeit der pulsbreitenmodulierten Lichtquelle entspricht, insofern unverändert zu lassen, dass innerhalb des gleichen Pulsbreitenmodulationszyklus gesehen sich ein durchschnittliches Tastverhältnis ergibt, welches dem eingestellten Tastverhältnis entspricht.

Mit anderen Worten wird erfindungsgemäß die durch die Helligkeitssteuerung einzustellende Hellzeit, welche mit einer Pulsbreitenmodulation über einen je nach einzustellender Helligkeit über einen jeweiligen Bereich eines Pulsbreitenmodulationszyklus konstant wäre, in einzelnen Zeitabschnitten weiterhin so moduliert (»Multi-Level-Modulation«), dass eine Übertragung von Daten mittels einer Kodierung über die innerhalb eines Pulsbreitenmodulationszyklus pulsbreitenmodulierte Hellzeit ermöglicht wird, ohne dass die mittels der an sich vorgegebenen Pulsbreitenmodulation eingestellte Helligkeit über den Pulsbreitenmodulationszyklus und auch insgesamt eine Veränderung erfährt.

Dabei wird erfindungsgemäß die Trägheit des menschlichen Auges ausgenutzt, welche eine kurzzeitige Änderung in der Pulsbreitenmodulation nicht als wahrnehmbare Helligkeitsunterschiede wahrnehmen kann. Dieses Prinzip wird im Übrigen bereits durch die - »erste« - Pulsbreitenmodulation zur Helligkeitseinstellung selbst angewandt.

Als besonderer Vorteil des erfindungsgemäßen Verfahrens ist eine gegenüber den aus dem Stand der Technik bekannten Verfahren erreichbare Erhöhung der Datenübertragungsrate um ein Vielfaches zu nennen.

Gemäß einer bevorzugten Ausgestaltungsform der Erfindung ist die Lichtquelle als lichtemittierende Diode ausgeführt, welche insbesondere den Vorteil einer kurzen und präzisen Anschaltzeit bietet.

Die Erfindung wird vorzugsweise für einen drahtlosen Austausch zwischen der Lichtquelle und einem mobilen Endgerät eingesetzt.

Gemäß einer Ausführungsform der Erfindung erfolgt eine Datenübertragung in Form von Symbolen, wobei ein Symbol aus einem oder mehreren binären Bits besteht.

Gemäß einer weiteren Ausführungsform der Erfindung wird der Wert eines Symbols weiterhin durch eine Anordnung der Dunkeltastung innerhalb des Signalverlaufs in einem Pulsbreitenmodulationszyklus kodiert. Diese Ausgestaltung der Erfindung entspricht einer Pulspositionsmodulation, bei der, unbeschadet der erfindungsgemäßen Vorgaben, eine Anordnung der Teilhellzeiten verändert wird.

In der einfachsten Ausgestaltung dieser Ausführungsform kann dabei die Position der Hellzeit - d.h. Lichtquelle eingeschaltet - mit der der Dunkelzeit - d.h. Lichtquelle ausgeschaltet - vertauscht werden, um auf diese Weise ein weiteres binäres Bit zu kodieren. Auch die vorgenannte Pulspositionsmodulation führt im Übrigen nicht zu einer wahrnehmbaren Änderung in der eingestellten Helligkeit.

Die Erfindung schafft ferner eine Vorrichtung zur optischen Übertragung von Daten mittels einer pulsbreitenmodulierten Lichtquelle.

Im Weiteren werden bevorzugte Ausführungsformen der erfindungsgemäßen Vorrichtung und des erfindungsgemäßen Verfahrens zur optischen Übertragung von Daten mittels einer pulsbreitenmodulierten Lichtquelle unter Bezugnahme auf die Zeichnung zur Erläuterung erfindungswesentlicher Merkmale beschrieben.

Es zeigen:

Figur 1A    eine Prinzipdarstellung einer pulsbreitenmodulierten Lichtquelle gemäß dem Stand der Technik;

Figur 1B    eine Prinzipdarstellung einer Ausführungsform der erfindungsgemäßen Vorrichtung zur optischen Übertragung von Daten mittels einer pulsbreitenmodulierten Lichtquelle;

Figur 2A    ein Signaldiagramm zur Erläuterung der Funktionsweise einer pulsbreitenmodulierten Lichtquelle gemäß dem Stand der Technik;

Figur 2B    ein Signaldiagramm zur Erläuterung der Funktionsweise des erfindungsgemäßen Verfahrens zur optischen Übertragung von Daten mittels einer pulsbreitenmodulierten Lichtquelle; und;

Figur 3    eine graphische Darstellung eines Zusammenhangs zum Einfluss von Bestimmungsgrößen auf die Anzahl möglicher Symbollängen.

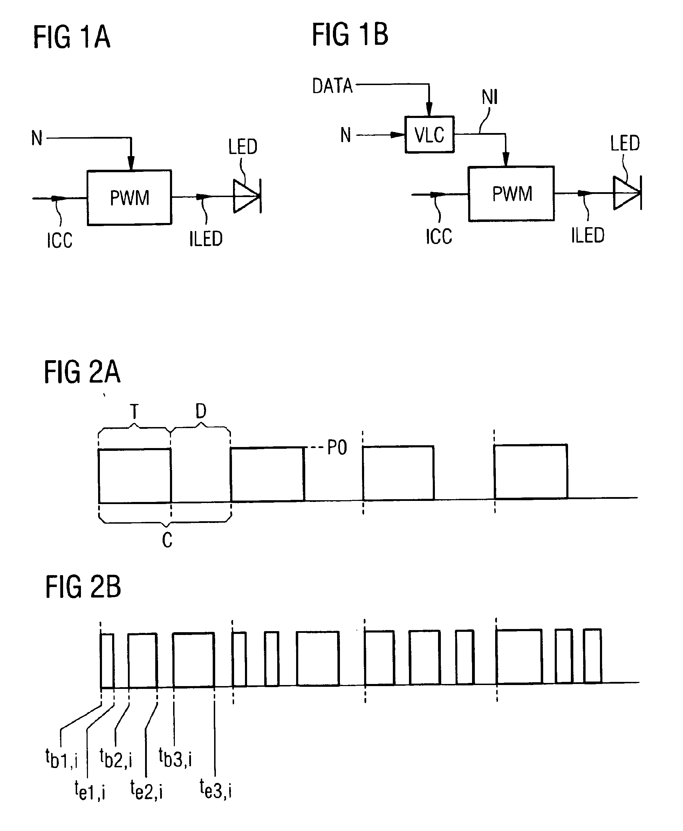

Figur 1A zeigt eine aus dem Stand der Technik bekannte Vorrichtung, bestehend aus einer Lichtquelle LED, einem Pulsbreitenmodulator PWM, durch den ein pulsbreitenmoduliertes Trägersignal generiert wird. Der Pulsbreitenmodulator PWM wird mit einem Versorgungsstrom ICC gespeist. Der Versorgungsstrom ICC ist beispielsweise ein Gleichstrom mit wählbarer Größe. Eine Helligkeitseinstellung der Lichtquelle LED erfolgt mittels einer Einstellung eines Dimmfaktor N, wobei beispielsweise eine Stellgröße eines entsprechenden - nicht dargestellten - Einstellglieds den Dimmfaktor beeinflusst und die Stellgröße an den Pulsbreitenmodulator PWM zugeführt wird. Der Dimmfaktor N entspricht dabei einem Tastverhältnis des vom Pulsbreitenmodulator PWM aufgrund des eingestellten Dimmfaktors erzeugten Stroms ILED, welche eine Pulsbreitenmodulation aufweist, die in ihrem zeitlichen Verlauf einem im Folgenden gezeigten Verlauf der optischen Leistung der Lichtquelle LED entspricht.

Die weitere Figurenbeschreibung erfolgt unter weiterer Bezugnahme auf die Funktionseinheiten von jeweils vorausgehenden Figuren. Identische Bezugszeichen in verschiedenen Figuren repräsentieren hierbei identische Funktionseinheiten.

Figur 2A zeigt einen zeitlichen Verlauf der optischen Leistung der Lichtquelle LED, wobei der zeitliche Verlauf der optischen Leistung sich in Folge des in seinem Verlauf im Wesentlichen identischen pulsbreitenmodulierten Stroms ILED einstellt.

In Figur 2A sind vier Pulsbreitenmodulationszyklen C dargestellt, wobei ein jeweiliger Zyklus C aus einer jeweiligen Hellzeit T und Dunkelzeit D besteht. In der Zeichnung ist die Bezeichnung der jeweiligen Hellzeit T und Dunkelzeit D aus Übersichtsgründen lediglich für den ersten ganz links abgebildeten Pulsbreitenmodulationszyklus C dargestellt. Ein jeweiliger Zyklus gemäß Figur 2A beginnt jeweils an einer senkrecht zur Abszisse strichliert dargestellten Linie und endet entsprechend an der darauf folgenden strichliert dargestellten Linie.

Während der Hellzeit T ist die Lichtquelle angesteuert und strahlt eine optische Leistung mit einem optischen Leistungsbetriebswert P0 aus. Während der Dunkelzeit D ist die Lichtquelle abgeschaltet und strahlt eine Leistung ab, die im Wesentlichen gleich Null ist.

Die Pulsbreitenmodulation der Lichtquelle LED dient einer Einstellung der optischen Leistung, wobei die Trägheit des menschlichen Auges dergestalt ausgenutzt wird, dass aufgrund der zeitlichen Länge eines Zyklus C die Hellzeiten T und Dunkelzeiten D als kontinuierliche optische Leistung empfunden werden.

Abhängig vom Dimmfaktor N, welcher in der folgenden mathematischen Notierung als $\eta$ gekennzeichnet wird und der sich als Quotient zwischen der Dunkelzeit D - in der folgenden mathematischen Notierung als $T_d$ gekennzeichnet - innerhalb eines Zyklus C sowie der Zyklusdauer C - in der folgenden mathematischen Notierung als $T_C$ gekennzeichnet - ergibt,

$$\eta = \frac{T_d}{T_c} \qquad\qquad (1)$$

ist die Helligkeit der Lichtquelle LED variierbar. Der Dimmfaktor $\eta$ ist identisch mit dem gleichfalls als Quotient zwischen der Dunkelzeit D sowie der Zyklusdauer C definierten Tastverhältnis.

Bei einem Dimmfaktor $\eta$ = 1 wird die optisch abgestrahlte Leistung zu 0, d.h. völlige Dunkelheit, bei einem Dimmfaktor $\eta$ = 0 entspricht die wahrgenommene optische Leistung dem optischen Leistungsbetriebswert P0, d.h. der maximal vorgesehenen Helligkeit.

Der in Figur 2A zeichnerisch dargestellte Dimmfaktor $\eta$ ergibt sich zu ca. 0,46.

Der vorliegenden Erfindung liegt nun die Aufgabe zugrunde, Maßnahmen zu schaffen, um die gemäß der Figur 2A pulsweitenmodulierte Lichtquelle LED zusätzlich zur optischen Übertragung von Daten vorzusehen.

Die Erfindung löst die gestellte Aufgabe dadurch, dass die Hellzeit T mit mindestens einer Dunkeltastung in mindestens eine erste und zweite Teilhellzeit aufgeteilt wird, so dass über Beginn und/oder zeitliche Länge der mindestens einen Dunkeltastung die zu übertragenden Daten kodiert werden.

Figur 2B zeigt ein zeitliches Ablaufdiagramm einer Pulsbreitenmodulation in Anwendung der erfindungsgemäßen Mittel. Wie in Figur 2A ist auch in der Figur 2B die optische Leistung der Lichtquelle LED auf der Ordinate über die Zeitabszisse aufgetragen. Ein jeweiliger Zyklus gemäß Figur 2B beginnt in Analogie zur Darstellung der Figur 2A jeweils an einer senkrecht zur Abszisse strichliert dargestellten Linie und endet entsprechend an der darauf folgenden strichliert dargestellten Linie.

Zunächst wird in der Darstellung der Figur 2B Bezug genommen auf den ersten Zyklus C im linken Teil des zeitlichen Ablaufdiagramms, bei dem die gesamte Hellzeit T des ersten Zyklus gemäß Figur 2A in drei Teilhellzeiten »aufgeteilt« ist, so dass die Summe der Teilhellzeiten innerhalb des Pulsbreitenmodulationszyklus C der Hellzeit T gemäß Figur 2A entspricht.

Ein Beginn einer ersten bzw. i-ten Hellzeit $t_{b1,i}$ im ersten bzw. i-ten Pulsbreitenmodulationszyklus C, im Folgenden auch ersten Zyklus C, erfolgt am äußersten linken Ende des zeitlichen Ablaufdiagramms gemäß Figur 2B. Das Ende der ersten Teilhellzeit endet zum Zeitpunkt $t_{e1,i}$. Die erste Teilhellzeit wird durch eine unmittelbar sich anschließende Dunkeltastung von einer zweiten Teilhellzeit getrennt, welche zu einem Zeitpunkt $t_{b2,i}$ beginnt und zu einem Zeitpunkt $t_{e2,i}$ ändert. An die zweite Teilhellzeit schließt sich eine zweite Dunkeltastung an, welche mit dem Beginn $t_{b3,i}$ einer dritten Teilhellzeit endet. Die besagte dritte Teilhellzeit endet zum Zeitpunkt $t_{e3,i}$.

In einem sich an den ersten Zyklus C anschließenden zweiten Zyklus C ist die gesamte Hellzeit T des zweiten Zyklus gemäß Figur 2A wiederum in drei Teilhellzeiten »aufgeteilt«.

Erfindungsgemäß entspricht auch im zweiten Zyklus C die Summe der Teilhellzeiten gemäß Figur 2B der Hellzeit T gemäß Figur 2A.

Auf Basis eines nunmehr zu übertragenden verschiedenen Symbols in der für die Datenübertragung zu übertragenden Symbolfolge hat sich im zweiten Zyklus C die Kodierung der Signalfolge, d.h. die zeitliche Abfolge der einzelnen Dunkeltastungen, im zweiten Zyklus C verändert. Im zweiten Zyklus C ist anhand von Figur 2B zu erkennen, dass eine - nicht bezeichnete - erste Dunkeltastung im zweiten Zyklus gemäß ihrem zeitlichen Beginn und ihrer zeitlichen Länge der ersten Dunkeltastung im ersten Zyklus entspricht. Eine sich an eine darauf folgende zweite Teilhellzeit anschließende zweite Dunkeltastung beginnt jedoch früher als die zweite Dunkeltastung im ersten Zyklus, hat im Übrigen jedoch eine mit der zweiten Dunkeltastung im ersten Zyklus identische zeitliche Länge.

In einem sich an den zweiten Zyklus C anschließenden dritten Zyklus C ist die gesamte Hellzeit T des dritten Zyklus C gemäß Figur 2A wiederum in drei Teilhellzeiten »aufgeteilt«. Erfindungsgemäß entspricht auch im dritten Zyklus C die Summe der Teilhellzeiten gemäß Figur 2B der Hellzeit T gemäß Figur 2A.

Auf Basis eines nunmehr zu übertragenden verschiedenen Symbols in der für die Datenübertragung zu übertragenden Symbolfolge hat sich die Kodierung der Signalfolge, d.h. die zeitliche Abfolge der einzelnen Dunkeltastungen, im dritten Zyklus C erneut verändert. Im dritten Zyklus C ist anhand von Figur 2B zu erkennen, dass sich eine - nicht bezeichnete - erste Dunkeltastung im dritten Zyklus gemäß ihrem zeitlichen Beginn sowohl von der ersten Dunkeltastung im ersten Zyklus als auch von der ersten Dunkeltastung im zweiten Zyklus unterscheidet.

In einem sich an den dritten Zyklus C anschließenden vierten Zyklus C hat sich die Kodierung der Signalfolge auf Basis eines nunmehr zu übertragenden verschiedenen Symbols erneut verändert.

In Figur 2B ist eine Ausführungsform der Erfindung dargestellt, gemäß der eine Aufteilung der Hellzeit T mit zwei Dunkeltastungen in drei Teilhellzeiten aufgeteilt wird.

Aus Gründen einer vereinfachten Darstellung zeigt die Figur 2B lediglich Dunkeltastungen, deren zeitliche Länge jeweils gleiche Werte aufweisen. Zur Erreichung einer höheren Kodierungstiefe empfiehlt es sich gemäß einer alternativen Ausführungsform der Erfindung jedoch auch, die zeitliche Länge der jeweiligen Dunkeltastungen gemäß der gewählten Kodierungstiefe und in Anwendung des erfindungsgemäßen Verfahrens zu variieren.

Zusammenfassend ist festzustellen, dass sich über den Beginn sowie über die zeitliche Länge einer jeweiligen Dunkeltastung eine Vielzahl möglicher Kodierungswerte ergibt.

Für eine gewählte Ausführungsform mit zwei Dunkeltastungen gemäß Figur 2B ergibt sich eine Anzahl der möglichen zu kodierenden Symbole #s gemäß

$$\# s = (N - a - g - 1)\left(\frac{N}{2} - 1 - \frac{3g}{2} - \frac{3a}{2}\right) - \frac{1}{2}(1 + g + a)(2 + g + a)$$

wobei

#s     die Anzahl der möglichen Symbole,

N     die zeitliche Gesamtlänge des von Dunkeltastungen zerteilten Blocks, also, gemäß Figur 2B, der dimensionslose Wert der Zeitdauer $t_{e3,i}$ - $t_{b1,i}$

a     eine minimal zulässige Länge der ersten Teilhellzeit,

g     eine minimal zulässige Länge der zweiten Teilhellzeit

ist.

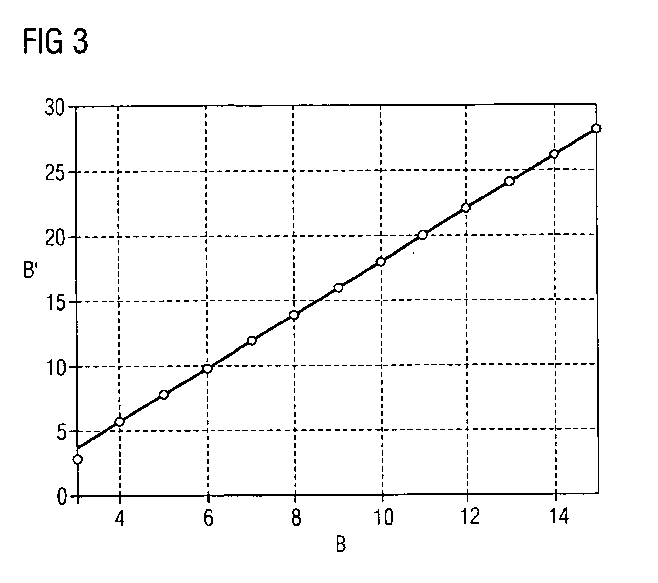

Zur Größe der Symbollänge lässt sich ein in Figur 3 dargestellte Zusammenhang zwischen den im Folgenden erläuterten Größen B und B' herleiten. Für die Werte von a und g wird dabei vereinfachender Weise ein Wert von 1 angenommen. Weiterhin gibt es $2^B$ prinzipiell mögliche Positionen für die Dunkeltastungen innerhalb der Hellzeit.

Für eine Anzahl möglicher Symbole #s wird dabei eine binäre Kodierung gemäß #s = ($2^{B'}$ - 1) angenommen.

Der auf der Ordinate des in Figur 3 gezeigten Zusammenhang dargestellte Wert von B' entspricht dabei einer größten durch ein jeweiliges Symbol darstellbaren Binärzahl. Die auf der Abszisse aufgetragene Größe B ist die zu B' zughörige nächste ganze Zahl. Für sehr große Werte von N ergibt sich dabei die lineare Näherung

$$B' \approx 2.0074B - 2.1576$$

Ähnliche Beziehungen lassen sich für drei und mehr Dunkeltastungen herleiten.

In Figur 1B ist eine erfindungsgemäße Anordnung zur Übertragung von Daten über eine pulsbreitenmodulierte Lichtquelle dargestellt. Neben den aus Figur 1A bekannten Funktionskomponenten ist ein erfindungsgemäßes Datenmodulationsmodul VLC vorgesehen, mittels dessen im Unterschied zur Anordnung gemäß Figur 1A Signalinformationen NI an den Pulsbreitenmodulator PWM zugeführt werden.

Die Signalinformationen NI werden erfindungsgemäß aus den an das Datenmodulationsmodul VLC zugeführten Daten DATA und aus den zur Helligkeitseinstellung dienenden Dimmfaktor N berechnet. Die Signalinformationen NI liegen beispielsweise als digitale Daten vor, welche z.B. die aus Figur 2B bekannten Zeitwerte $t_{b1,i}$, $t_{e1,i}$ usw. charakterisieren.

Der Pulsbreitenmodulator PWM gemäß Figur 1B synthetisiert aus den Signalinformationen NI einen Strom ILED, welcher einen zeitlichen Verlauf gemäß Figur 2B aufweist.

Es versteht sich von selbst, dass ein Ausführungsbeispiel gemäß Figur 1B lediglich exemplarisch zu verstehen ist und dass in einer praktischen Realisierung mehrere Lichtquellen vorgesehen sein können. In einer alternativen Ausführungsform der Erfindung kann die Berechnung und Synthetisierung des erfindungsgemäßen pulsbreitenmodulierten Verlaufs z.B. direkt in einem Kommunikationsmodul erfolgen.

Bei einer praktischen Realisierung der Erfindung wird z.B. eine handelsübliche lichtemittierende Diode mit einer minimal realisierbaren Pulslänge von 4 ns gewählt. Für eine typische Pulsbreitenmodulation ergibt sich eine Wiederholrate von bis zu 500 kHz.

Der kürzeste mit der genannten handelsüblichen Leuchtdiode erzeugbare Puls ist ca. 4 ns lang, so dass 625 Pulse in ein Zyklus passen, was einem B von 9 entspricht. Mit nur einem Dunkeltastung lässt sich somit bei sehr kleinem Dimmfaktor gemäß

$$9 \text{ bit} \cdot 500 \text{ kHz} = 4,5 \text{ Mbit/s}$$

eine Datenübertragungsrate von 4.5 Mbit/s erzielen. Erfindungsgemäß kann diese Rate in einfacher Weise, nämlich durch Erhöhung der Anzahl von Dunkeltastungen auf einen Wert von zwei auf eine Datenübertragungsrate von

$$17\ \mathtt{bit} \cdot 500\ \mathtt{kHz} = 8,5\ \mathtt{Mbit/s}$$

erhöhen.

Um im Fall einer ungedimmten Beleuchtung mit maximaler Helligkeit, also $\eta = 0$, Daten zu übertragen, wird gemäß einer weiteren Ausgestaltung der Erfindung wie folgt vorgegangen. Hierbei ist vorgesehen, die vorgesehene Anzahl an Dunkeltastungen beizubehalten und die emittierte optische Leistung entsprechend zu erhöhen, so dass ein Beitrag der Dunkeltastungen zur Reduzierung der Beleuchtungsstärke ausgeglichen wird.

Weist der Zyklus C beispielsweise eine zeitliche Länge auf, welcher einer Länge von 625 Dunkeltastungszeiten entspricht, so wird der optischen Leistungsbetriebswert P0 um einen Wert erhöht, welcher zwei Dunkeltastungszeiten entspricht. Im vorliegenden Beispiel wird der optischen Leistungsbetriebswert P0 um einen Wert von 625/623, mithin ca. 0.5 % erhöht.

Da somit die mittlere emittierte Lichtleistung unverändert bleibt, kann auch mit ungedimmtem Licht Information übertragen werden.

Mit einer Erhöhung des Dimmfaktors geht eine Verkürzung der für die Kodierung zur Verfügung stehenden Hellzeit T einher. Für kürzere Hellzeiten kann es aus Sicht der übertragenen Datenrate vorteilhaft sein, die Anzahl der Dunkeltastungen zu verringern.

Um einer Einstellung der Beleuchtungsstärke und damit einer Änderung der Hellzeit T Rechnung zu tragen, wird außerdem vorgeschlagen, in regelmäßigen Abständen und mindestens einmal am Anfang einer Datenübertragung Trainingssymbole enthaltende Traingssequenzen zu senden.

Derartige Traingssequenzen können beispielsweise Trainingssymbole mit minimalem Abstand der Dunkeltastungen beinhalten. Des weiteren können diese Traingssequenzen Trainingssymbole enthalten, in denen die äußersten zwei Dunkeltastungen einen maximalen Abstand haben.

Somit können auf der Gegenseite in einfacher Weise die vorgesehene Anzahl an Dunkeltastungen sowie deren größte verwendete Abstand bestimmt werden.

Weiterhin erleichtern Trainingssequenzen der Gegenseite eine Synchronisation mit der Lichtquelle mittels einer Taktrückgewinnung aus dem optischen Signal.

Das erfindungsgemäße Verfahren zur optischen Übertragung von Daten verursacht keine elektromagnetischen Wellen und kann auch nicht durch elektromagnetische Wellen beeinflusst werden. Das erfindungsgemäße Verfahren kann insbesondere dann eingesetzt werden, wenn bereits eine LED-Beleuchtung vorgesehen ist. Dabei können die Leuchtdioden beispielsweise mit einem Powerline-Übertragungsverfahren adressiert werden.

Die Übertragung der Daten erfolgt mittels eines leicht abschirmbaren Kommunikationsmediums. Da die Daten optisch übertragen werden, kann man sie beispielsweise leicht mit einer Wand oder einem Vorhang von einer Umgebung abschirmen. Es kann daher eine Abhörsicherheit erreicht werden.

Das erfindungsgemäße Verfahren erlaubt die sichere optische Übertragung von Daten über eine dimmbare Leuchtdiode LED zu tragbaren Endgeräten innerhalb eines beleuchteten Raumes und ist unempfindlich gegenüber Funksignalen. Es können beliebige Leuchtdioden LED eingesetzt werden, beispielsweise Leuchtdioden, die ein weißes Licht erzeugen. Alternativ können auch Lichtdioden mit einer geringeren Modulationsbandbreite als weiße Leuchtdioden eingesetzt werden.

**Patentansprüche**

**1.** Verfahren zur optischen Übertragung von Daten mittels einer pulsbreitenmodulierten Lichtquelle (LED),

- bei dem für eine Helligkeitseinstellung der Lichtquelle (LED) ein Tastverhältnis (N) einer Pulsbreitenmodulation als Verhältnis zwischen einer Dunkelzeit (D) der Lichtquelle (LED) und einer Periodenlänge (C) eines Pulsbreitenmodulationszyklus vorgegeben ist, wobei eine Differenz aus Periodenlänge (C) und Dunkelzeit (D) einer Hellzeit (T) der Lichtquelle (LED) innerhalb eines Pulsbreitenmodulationszyklus entspricht,
- wobei die Hellzeit (T) mit mindestens einer Dunkeltastung in mindestens eine erste und zweite Teilhellzeit aufgeteilt wird, so dass über Beginn und/oder zeitliche Länge der mindestens einen jeweiligen Dunkeltastung die zu übertragenden Daten (DATA) kodiert werden, und,
- wobei die Summe der Teilhellzeiten innerhalb des Pulsbreitenmodulationszyklus im Wesentlichen der Hellzeit gemäß dem vorgegebenen Tastverhältnis entspricht.

**2.** Verfahren nach Anspruch 1, bei dem die Hellzeit (T) mit mehreren Dunkeltastungen in mehrere Teilhellzeiten aufgeteilt wird.

**3.** Verfahren nach einem der vorhergehenden Ansprüche, bei dem eine zeitliche Länge der jeweiligen Dunkeltastung gemäß einer gewählten Kodierungstiefe variiert wird.

**4.** Verfahren nach einem der vorhergehenden Ansprüche, bei dem eine Anzahl der Dunkeltastungen beibehalten wird und die emittierte optische Leistung so erhöht wird, dass ein Beitrag der Dunkeltastung zur Reduzierung der Beleuchtungsstärke ausgeglichen wird.

**5.** Verfahren nach einem der vorhergehenden Ansprüche, wobei die Lichtquelle (LED) eine lichtemittierende Diode ist.

**6.** Verfahren nach einem der vorgenannten Ansprüche, wobei die Daten drahtlos mit einem mobilen Endgerät ausgetauscht werden.

**7.** Verfahren nach einem der vorgenannten Ansprüche, wobei die Daten in mindestens einem Symbol übertragen werden und wobei ein Symbol durch mindestens ein binäres Bit definierbar ist.

**8.** Verfahren nach einem der vorgenannten Ansprüche, wobei ein Wert eines Symbols zumindest teilweise durch eine Anordnung der Dunkeltastung innerhalb des Pulsbreitenmodulationszyklus (C) kodiert wird.

**9.** Verfahren nach einem der vorgenannten Ansprüche, wobei Trainingssymbole enthaltende Traingssequenzen zu Beginn einer Datenübertragung vorgesehen sind.

**10.** Verfahren nach Anspruch 9, wobei ein Trainingssymbol durch einen minimalen Abstand zwischen mindestens zwei Dunkeltastungen gestaltet ist.

**11.** Verfahren nach einem der Ansprüche 9 oder 10, wobei ein Trainingssymbol durch einen maximalen Abstand zwischen der ersten und der letzten Dunkeltastung gestaltet ist.

**12.** Verfahren nach Anspruch 11, wobei bei einem eingestellten Tastverhältnis von Null eine optische Leistung der Lichtquelle um einen Faktor erhöht wird, der einem Quotienten aus einer zeitlichen Dauer des Pulsbreitenmodulationszyklus (C) und eines um eine zeitliche Dauer der Dunkeltastungen reduzierten Wertes der zeitlichen Dauer des Pulsbreitenmodulationszyklus (C) entspricht.

**13.** Vorrichtung zur optischen Übertragung von Daten mittels einer pulsbreitenmodulierten Lichtquelle (LED) mit:

- einem Datenmodulationsmodul (VLC) zur Entgegennahme von zu übertragenden Daten (DATA) und eines einzustellenden Tastverhältnis (N) einer Pulsbreitenmodulation als Verhältnis zwischen einer Dunkelzeit (D) der Lichtquelle (LED) und einer Periodenlänge (C) eines Pulsbreitenmodulationszyklus, wobei eine Differenz aus Periodenlänge (C) und Dunkelzeit (D) einer Hellzeit (T) der Lichtquelle (LED) innerhalb eines Pulsbreitenmodulationszyklus entspricht,
- das Datenmodulationsmodul (VLC) weiter eingerichtet zur Definition mindestens einer Dunkeltastung, durch die die Hellzeit in mindestens eine erste und zweite Teilhellzeit aufgeteilt wird, so dass über Beginn und/oder zeitliche Länge der mindestens einen jeweiligen Dunkeltastung die zu übertragenden Daten (DATA) kodiert werden, so dass die Summe der Teilhellzeiten innerhalb des Pulsbreitenmodulationszyklus im Wesentlichen der Hellzeit gemäß dem vorgegebenen Tastverhältnis entspricht.

**14.** Vorrichtung gemäß Anspruch 13 mit Mitteln zur Ausführung des Verfahrens nach einem der Ansprüche 1 bis 12.

**Claims**

**1.** Method for optically transmitting data by means of a pulse-width-modulated light source (LED),

- in which a pulse duty factor (N) of a pulse width modulation is specified to set the brightness of the light source (LED) as a ratio between a blanking time (D) of the light source (LED) and a period (C) of a pulse width modulation cycle, wherein a difference between the period (C) and the blanking time (D) corresponds to a bright-up time (T) of the light source (LED) within one pulse width modulation cycle,
- wherein, with at least one blanking, the bright-up time (T) is divided into at least one first and second partial bright-up time so that the data (DATA) to be transmitted is encoded by means of the start and/or time period of the at least one respective blanking, and
- wherein the sum of the partial bright-up times within the pulse width modulation cycle essentially corresponds to the bright-up time according to the specified pulse duty factor.

2. Method according to claim 1, wherein the bright-up time (T) is divided into several partial bright-up times using several blankings.

3. Method according to one of the preceding claims, wherein a time period of the respective blanking is varied in accordance with a selected encoding depth.

4. Method according to one of the preceding claims, wherein a number of the blankings is retained and the emitted optical power is increased so that a contribution of the blanking to the reduction of the luminance level is evened out.

5. Method according to one of the preceding claims, wherein the light source (LED) is a light-emitting diode.

6. Method according to one of the preceding claims, wherein the data is exchanged wirelessly with a mobile terminal.

7. Method according to one of the preceding claims, wherein the data is transmitted in at least one symbol, and wherein a symbol can be defined by at least one binary bit.

8. Method according to one of the preceding claims, wherein a value of a symbol is encoded at least partially by an arrangement of the blanking within the pulse width modulation cycle (C).

9. Method according to one of the preceding claims, wherein training sequences containing training symbols are provided at the start of a data transmission.

10. Method according to claim 9, wherein a training symbol is formed by a minimum distance between at least two blankings.

11. Method according to one of claims 9 or 10, wherein a training symbol is formed by a maximum distance between the first and the last blanking.

12. Method according to claim 11, wherein with a pulse duty factor set to zero, an optical power of the light source is increased by a factor which corresponds to a quotient of a time period of the pulse width modulation cycle (C) and of a value of the time period of the pulse width modulation cycle (C) reduced by a time period of the blankings.

13. Device for optically transmitting data by means of a pulse-width-modulated light source (LED) having:

- a data modulation module (VLC) for receiving data (DATA) to be transmitted and a settable pulse duty factor (N) of a pulse width modulation as a ratio between a blanking time (D) of the light source (LED) and a period (C) of a pulse width modulation cycle, wherein a difference between the period (C) and the blanking time (D) corresponds to a bright-up time (T) of the light source (LED) within one pulse width modulation cycle;
- the data modulation module (VLC) is furthermore set up for the definition of at least one blanking by which the bright-up time is divided into at least one first and second partial bright-up time, so that the data (DATA) to be transmitted is encoded by means of the start and/or time period of the at least one respective blanking, so that the sum of the partial bright-up times within the pulse width modulation cycle essentially corresponds to the bright-up time according to the specified pulse duty factor.

14. Device according to claim 13, having means for implementing the method according to one of claims 1 to 12.

**Revendications**

1. Procédé de transmission optique de données au moyen d'une source lumineuse (LED) modulée en largeur d'impulsion, selon lequel :

- un rapport cyclique (N) d'une modulation en largeur d'impulsion est prédéterminé, pour un réglage de la luminosité de la source lumineuse (LED), en tant que rapport entre un temps de non-éclairage (D) de la source lumineuse (LED) et une longueur de période (C) d'un cycle de modulation en largeur d'impulsion, une différence entre la longueur de période (C) et le temps de non-éclairage (D) correspondant à un temps d'éclairage (T) de la source lumineuse (LED) dans les limites d'un cycle de modulation en largeur d'impulsion,
- le temps d'éclairage (T) présentant au moins une suppression de faisceau est réparti en au moins un premier et un deuxième temps partiels d'éclairage, de sorte que les données à transmettre (DATA) sont codées par le début et/ou la longueur temporelle de l'au moins une suppression de faisceau respective, et
- la somme des temps partiels d'éclairage, dans les limites du cycle de modulation en largeur d'impulsion, correspondant sensiblement au temps d'éclairage selon le rapport cyclique prédéterminé.

2. Procédé selon la revendication 1, selon lequel le temps d'éclairage (T) présentant plusieurs suppressions de faisceau est réparti en plusieurs temps partiels d'éclairage.

3. Procédé selon l'une des revendications précédentes, dans lequel on fait varier selon une profondeur de codage choisie une longueur temporelle de la suppression de faisceau respective.

4. Procédé selon l'une des revendications précédentes, selon lequel un nombre de suppressions de faisceau est maintenu et la puissance optique émise est augmentée de manière telle qu'une contribution de la suppression de faisceau à la réduction de l'intensité d'éclairage est compensée.

5. Procédé selon l'une des revendications précédentes, la source lumineuse (LED) étant une diode électroluminescente.

6. Procédé selon l'une des revendications précédentes, les données étant échangées sans fil avec un terminal mobile.

7. Procédé selon l'une des revendications précédentes, les données étant transmises dans au moins un symbole et un symbole pouvant être défini par au moins un bit binaire.

8. Procédé selon l'une des revendications précédentes, une valeur d'un symbole étant codée au moins en partie par un positionnement de la suppression de faisceau dans les limites du cycle de modulation en largeur d'impulsion (C).

9. Procédé selon l'une des revendications précédentes, des séquences d'apprentissage contenant des symboles d'apprentissage étant prévues au début d'une transmission de données.

10. Procédé selon la revendication 9, un symbole d'apprentissage étant formé par une distance minimale entre au moins deux suppressions de faisceau.

11. Procédé selon l'une des revendications 9 ou 10, un symbole d'apprentissage étant formé par une distance maximale entre la première et la dernière suppression de faisceau.

12. Procédé selon la revendication 11, une puissance optique de la source lumineuse étant, pour un rapport cyclique réglé de zéro, augmentée d'un facteur qui correspond au quotient d'une durée temporelle du cycle de modulation en largeur d'impulsion (C) et d'une valeur, réduite d'une durée temporelle des suppressions de faisceau, de la durée temporelle du cycle de modulation en largeur d'impulsion (C).

13. Dispositif de transmission optique de données au moyen d'une source lumineuse (LED) modulée en largeur d'impulsion, comportant :

- un module de modulation de données (VLC) pour accepter des données à transmettre (DATA) et un rapport cyclique (N) réglable d'une modulation en largeur d'impulsion, en tant que rapport entre un temps de non-éclairage (D) de la source lumineuse (LED) et une longueur de période (C) d'un cycle de modulation en largeur d'impulsion, une différence entre la longueur de période (C) et le temps de non-éclairage (D) correspondant à un temps d'éclairage (T) de la source lumineuse (LED) dans les limites d'un cycle de modulation en largeur d'impulsion ;
- le module de modulation de données (VLC) étant en outre conçu pour définir au moins une suppression de faisceau par laquelle le temps d'éclairage est subdivisé en au moins un premier et un deuxième temps d'éclairage partiels, de sorte que les données à transmettre (DATA) sont codées par le début et/ou la longueur temporelle de l'au moins une suppression de faisceau respective, de sorte que la somme des temps partiels d'éclairage, dans les limites du cycle de modulation en largeur d'impulsion, correspond sensiblement au temps d'éclairage selon le rapport cyclique prédéterminé.

**14.** Dispositif selon la revendication 13, comportant des moyens pour exécuter le procédé selon l'une des revendications 1 à 12.

## FIG 1A

## FIG 1B

## FIG 2A

## FIG 2B

## FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009019203
- DE 102010005885

- WO 0225842 A2